# EUROPEAN PATENT SPECIFICATION

(11) **EP 4 467 274 B1**
(45) Date of publication and mention of the grant of the patent: **05.08.2026**
(21) Application number: 23743211.7
(22) Date of filing: 16.01.2023
(51) Int. Cl.: B23K 1/005, B23K 26/073, B23K 26/08, B23K 26/082, F21S 2/00, F21V 19/02, H01S 5/11, H01S 5/18, F21Y 115/30, B23K 1/00, B23K 26/06, B23K 26/20, H01S 5/42

(54) **LASER IRRADIATION METHOD AND LASER IRRADIATION DEVICE**
LASERBESTRAHLUNGSVERFAHREN UND LASERBESTRAHLUNGSVORRICHTUNG
PROCÉDÉ D'IRRADIATION LASER ET DISPOSITIF D'IRRADIATION LASER

(30) Priority: 19.01.2022 JP 2022006521
(43) Date of publication of application: 27.11.2024
(73) Proprietor: Kyoto University, Kyoto-shi, Kyoto 606-8501 (JP); Amada Co., Ltd., Isehara-shi, Kanagawa 259-1196 (JP)
(72) Inventor: NODA, Susumu, Kyoto-shi, Kyoto 606-8501 (JP); USUDA, Kaori, Isehara-shi, Kanagawa 259-1196 (JP)
(74) Representative: Grünecker Patent- und Rechtsanwälte PartG mbB
(86) International application number: PCT/JP2023/000970
(87) International publication number: WO 2023/140217

(56) References cited:
- JP-A- 2014 113 598
- JP-A- 2014 113 598
- JP-A- 2015 162 663
- JP-A- 2018 034 185
- JP-A- 2018 034 185
- JP-A- 2018 129 554
- JP-A- 2018 129 554
- US-A1- 2007 217 466
- US-A1- 2014 348 195
- US-A1- 2015 144 604
- HIROSE K ET AL: "Realization of high-power narrow beam divergence in photonic-crystal surface-emitting laser", 20140227, vol. 9002, 27 February 2014 (2014-02-27), pages 90021J - 90021J, XP060035228, DOI: 10.1117/12.2038659

## Description

### [TECHNICAL FIELD]

The present invention relates to a laser irradiation method and a laser irradiation apparatus.

### [BACKGROUND ART]

A technique is known which is for soldering an electronic component such as a semiconductor chip to a printed substrate using laser light and a solder. Patent Literature 1 discloses a method of soldering an electronic component to a printed substrate.

In the method disclosed in Patent Literature 1, for example, laser light such as a YAG laser enters a laser irradiation part through an optical fiber from a laser oscillator. The entered laser light has a direction which is changed by a deflection mirror and is scanned at an equal speed on the printed substrate. A plurality of soldering points where the electronic component is soldered are arranged on a scanning locus of the laser light on the printed substrate. Each soldering point is irradiated with the laser light due to an output of the laser light being ON by a Q-switch. The electronic component is soldered to the printed substrate by irradiating each soldering point with the laser light. Patent literature 2 discloses a laser irradiation method and apparatus according to the preamble of claims 1 and 8.

### [Citation List]

### [Patent Literature]

[Patent Literature 1] Japanese Unexamined Patent Application Publication No. Sho 63-168086
[Patent literature 2] JP 2018 129554 A

### [SUMMARY OF INVENTION]

In the method disclosed in Patent Literature 1, the YAG laser is exemplified, but if the deflection mirror is not used, a diode laser (semiconductor laser) using a Fabry-Perot resonator is used as a laser light source in a general laser soldering apparatus. The laser light radiated from the Fabry-Perot resonator has an elliptical-beam cross section because an emission diameter and a beam spread angle of the laser light differ in a horizontal direction and a vertical direction. Therefore, the beam cross section of the laser light is shaped into a circle by a Fiber Coupled Laser Diode (FCLD) in which an optical fiber is coupled to a diode laser.

In addition to the YAG laser, a direct diode laser (DDL) using a diode laser, which is a pump light source of a fiber laser in a general laser soldering apparatus, is also available in the market as a laser light source for processing. A collimating lens converts divergent laser light emitted from an end of an optical fiber for beam shaping into collimated light at a point closer to the optical fiber than the deflection mirror. The laser light collimated by the collimating lens is focused by a focusing lens and is used to irradiate each soldering point. An energy density of the laser beam focused by the focusing lens has a Gaussian distribution both before and after collimation performed by the collimating lens. It is necessary to irradiate each soldering point with a laser beam having a high energy density, and therefore a focusing lens is used which has a short focal length and reduces a beam diameter of a laser beam having an energy density of a Gaussian distribution. The Rayleigh length of the laser beam of which beam diameter is reduced by the focusing lens with a short focal length becomes short in accordance with the focal length of the focusing lens.

If the Rayleigh length of the laser beam is short, when a position of each soldering point is deviated in a height direction from a normal position, it is not possible to irradiate each soldering point with a laser beam having a necessary energy density. A position of each soldering point may be deviated in the height direction from the normal position due to warping of the printed substrate, for example. A position of each soldering point may be deviated in the height direction from the normal position depending on a rising state of a solder previously arranged on the printed substrate. If a position of each soldering point is deviated in the height direction and a position to be irradiated with the laser beam is no longer within the Rayleigh length range of the focused laser beam, it is not possible to irradiate each soldering point with a laser beam having a necessary energy density.

One aspect of the present invention provides a laser irradiation method according to claim 1.

One aspect of the present invention provides a laser irradiation apparatus according to claim 8.

A laser beam emitted from a photonic crystal surface emitting laser element is focused by a focusing lens and irradiated onto an object to be irradiated at any irradiation position within a Rayleigh length range. The laser beam emitted from the photonic crystal surface emitting laser element has a Gaussian waveform intensity distribution in a beam radial direction, and in a case of a Watt class element size, a beam spread angle in an optical axis direction is substantially absent and the laser beam is collimated. Therefore, it is not necessary to collimate the laser beam emitted from the photonic crystal surface emitting laser element by a collimating lens. Since a collimating lens is not necessary, an optical transmission path for entering a laser beam to a collimating lens is not necessary, and a laser beam can be entered to a focusing lens by means of spatial propagation.

Generally, a laser beam having a Gaussian waveform intensity distribution naturally radiates and diverges toward an optical axis direction of the laser beam from a laser light source, even if the laser beam is collimated light. Since the intensity of the laser beam is low at a hem portion of the Gaussian waveform, that is, at a peripheral edge portion in a beam radial direction of the laser beam, the laser beam attenuates toward an optical axis direction from a laser light source. However, at a propagation distance of the laser light of the laser soldering apparatus of the present disclosure, the collimated light does not substantially diverge or attenuate.

Further, if the area of a radiation region of the laser beam in the laser light source increases, a diffraction effect is suppressed and the beam comes to have a plane wave, and therefore collimated light having substantially no beam spread angle in an optical axis direction is obtained.

In other words, since the area of the radiation region of the photonic crystal surface emitting laser element becomes the area of the collimated light, the Rayleigh length of the light focused by the focusing lens can be longer than that of a general laser soldering apparatus.

In accordance with a laser irradiation method and a laser irradiation apparatus according to one aspect of the present invention, it is possible to irradiate an object to be irradiated, with a laser beam having a necessary energy density at a position in a wide range in an optical axis direction of the laser beam.

### [BRIEF DESCRIPTION OF DRAWINGS]

[FIG. 1A] Fig. 1A is a diagram showing an entire configuration example of a laser irradiation apparatus according to the present embodiment.
[FIG. 1B] Fig. 1B is a diagram showing the relationship between a beam waist position and a position of the Rayleigh length of a laser beam that has been focused by a focusing lens shown in Fig. 1A.
[FIG. 2A] Fig. 2A is a diagram showing a configuration example of a photonic crystal surface emitting laser element of a laser oscillator in the laser irradiation apparatus shown in Fig. 1A.
[FIG. 2B] Fig. 2B is a perspective view showing a detailed configuration example of each photonic crystal surface emitting laser element shown in Fig. 2A.
[FIG. 3] Fig. 3 is a diagram showing a principle of laser beam emission by a Fabry-Perot diode laser used as a laser light source for processing.
[FIG. 4A] Fig. 4A is a diagram showing an example of a soldering operation performed on a printed substrate by a general laser soldering apparatus using a fiber coupled laser diode as a laser light source.
[FIG. 4B] Fig. 4B is a diagram showing an example of an operation when soldering is performed on a printed substrate by the laser soldering apparatus of Fig. 4A using a line-shaped laser beam.
[FIG. 5A] Fig. 5A is a diagram showing a case where outputs of laser beams are increased by increasing the length of an optical resonator in a Fabry-Perot diode laser.
[FIG. 5B] Fig. 5B is a diagram showing a case where outputs of laser beams are increased by increasing the width of a light-emitting part in a Fabry-Perot diode laser.
[FIG. 5C] Fig. 5C is a diagram showing an example of a focusing optical path of a laser beam emitted by a fiber coupled laser diode in the laser soldering apparatus of Fig. 4A.
[FIG. 6A] Fig. 6A is a graph showing an example of the relationship between a focal length of a focusing lens and a beam diameter of a focused laser beam when a laser beam emitted by a fiber coupled diode laser is collimated and then focused by a focusing lens.
[FIG. 6B] Fig. 6B is a graph showing an example of the relationship between the focal length of the focusing lens shown in Fig. 6A and the Rayleigh length of the focused laser beam.
[FIG. 7] Fig. 7 is a diagram showing an example of a focusing optical path of a laser beam emitted by the photonic crystal surface emitting laser element shown in Fig. 2B in the laser irradiation apparatus shown in Fig. 1A
[FIG. 8A] Fig. 8A is a diagram showing that the photonic crystal surface emitting laser element shown in Fig. 2B confines light in an in-plane direction by means of a photonic crystal and radiates light in a vertical direction.
[FIG. 8B] Fig. 8B is a diagram showing an example of increasing a radiation area of a laser beam in the photonic crystal surface emitting laser element shown in Fig. 2B and achieving higher output.
[FIG. 9A] Fig. 9A is a graph showing an example of the relationship between a focal length of a focusing lens for focusing a single mode laser beam emitted by the photonic crystal surface emitting laser element shown in Fig. 2B in the laser irradiation apparatus shown in Fig. 1A, and a beam diameter of a focused laser beam.
[FIG. 9B] Fig. 9B is a graph showing an example of the relationship between the focal length of the focusing lens shown in Fig. 9A and the Rayleigh length of the focused laser beam.
[FIG. 10] Fig. 10 is a diagram showing examples of optical paths of laser beams radiated by two photonic crystal surface emitting laser elements of Fig. 2B of the laser oscillator shown in Fig. 1A.
[FIG. 11] Fig. 11 is a graph showing an example of the relationship between a beam interval and a focal length of a focusing lens of the two laser beams shown in Fig. 10.
[FIG. 12A] Fig. 12A is a diagram showing a position of each laser beam in a range of the Rayleigh length when the two laser beams shown in Fig. 10 are focused by one focusing lens having a focal length of 120 mm for each distance from a focal plane of the focusing lens.
[FIG. 12B] Fig. 12B is a diagram showing a position of each laser beam in a range of the Rayleigh length when the two laser beams shown in Fig. 10 are focused by one focusing lens having a focal length of 200 mm for each distance from a focal plane of the focusing lens.

### [DESCRIPTION OF EMBODIMENT]

The present embodiment will be described below with reference to the drawings. The same or equivalent parts or components are denoted with the same reference numerals throughout the drawings.

The following embodiment exemplifies an apparatus and the like for embodying technical ideas of the present disclosure. The technical ideas of the present disclosure do not specify a material, shape, configuration, arrangement, function, and the like of each component to the following.

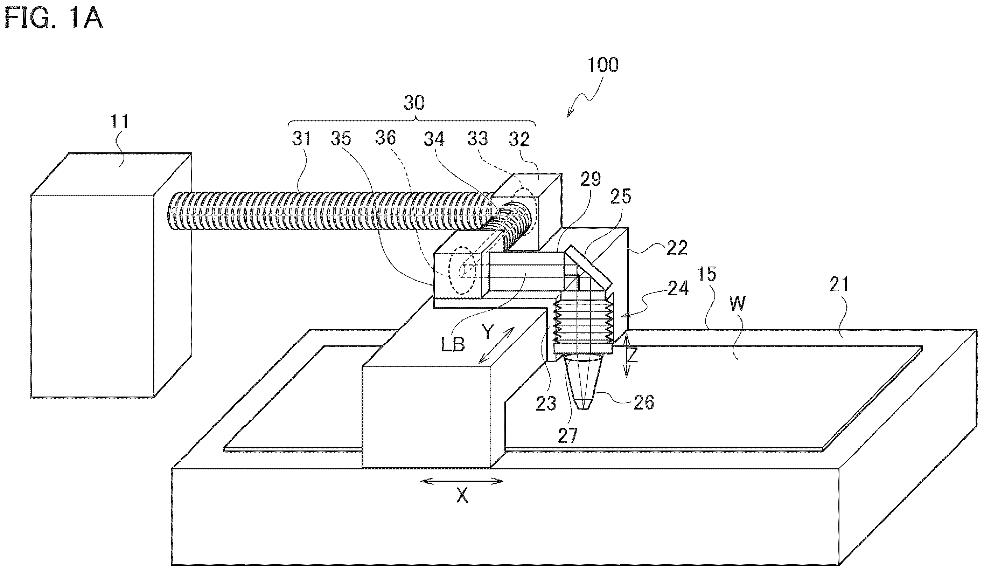

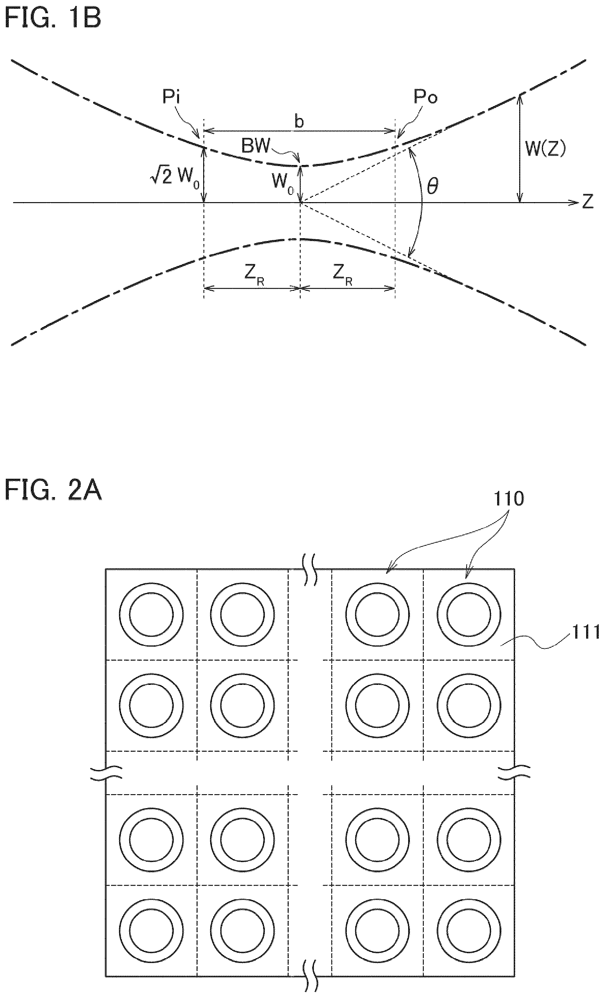

A laser irradiation apparatus for performing a laser irradiation method according to the present embodiment will be described below with reference to the drawings. Fig. 1A is a diagram showing an entire configuration example of the laser irradiation apparatus according to the present embodiment. Fig. 1B is a diagram showing the relationship between a beam waist position and a position of the Rayleigh length of a laser beam that has been focused by a focusing lens shown in Fig. 1A. Fig. 2A is a diagram showing a configuration example of a photonic crystal surface emitting laser element of a laser oscillator in the laser irradiation apparatus shown in Fig. 1A.

As shown in Fig. 1A, a laser irradiation apparatus 100 according to an embodiment includes: a photonic crystal surface emitting laser element 110 of Fig. 2A configured to emit a laser beam LB; a laser head 24 configured to focus the laser beam LB emitted from the photonic crystal surface emitting laser element 110 by a focusing lens 27 thereof in an optical transmission path by spatial propagation of the laser beam LB; and moving mechanisms 22, 23, and 24 configured to irradiate the laser beam LB focused by the focusing lens 27 onto an object to be irradiated W with the laser beam LB at any irradiation position within a Rayleigh length Z_{R} range of Fig. 1B regardless of a beam waist BW position of Fig. 1B of the laser beam LB in an optical axis direction by a movement of the focusing lens 27 relative to the object to be irradiated W along the optical axis direction of the laser beam LB.

Details of the laser irradiation apparatus 100 according to the present embodiment will be described below.

A case will be described where the laser irradiation apparatus 100 shown in Fig. 1A is an example of a laser soldering apparatus for performing soldering to an object to be irradiated with laser light. The laser irradiation apparatus 100 may be a laser cutting machine for cutting an object to be irradiated with laser light, a laser welding machine for welding, a surface modifying apparatus for modifying a surface of an object to be irradiated, or a marking apparatus for marking an object to be irradiated.

As shown in Fig. 1A, the laser irradiation apparatus 100 includes a laser oscillator 11, a laser processing unit 15, and a protection unit 30 for protecting the laser beam LB emitted from the laser oscillator 11 and transmitted to the laser processing unit 15.

The laser oscillator 11 includes the Photonic crystal Surface Emitting Lasers (PCSEL) element 110 (hereinafter abbreviated as "PCSEL element 110") shown in Fig. 2A. The PCSEL element 110 emits the laser beam LB. The laser beam LB emitted by the PCSEL element 110 has a Gaussian waveform intensity distribution in a beam radial direction of the laser beam LB.

Generally, a laser beam having a Gaussian waveform intensity distribution naturally radiates and diverges toward an optical axis direction of the laser beam from a laser light source, even if the laser beam is collimated light. Since the intensity of the laser beam is low at a hem portion of the Gaussian waveform, that is, at a peripheral edge portion in a beam radial direction of the laser beam, the laser beam attenuates more as it moves away from a laser light source in an optical axis direction. However, at a propagation distance of the laser light of the laser soldering apparatus of the present disclosure, the collimated light does not substantially diverge or attenuate.

Further, when the area of a radiation region of the laser beam in the laser light source increases, a diffraction effect is suppressed, the beam comes to have a plane wave, and therefore collimated light having substantially no beam spread angle in an optical axis direction is obtained. In the following description, the "collimated light having substantially no beam spread angle in the optical axis direction" will be referred to as "collimated light" or "substantially collimated light".

The laser beam LB having the Gaussian waveform intensity distribution, which is emitted from the PCSEL element 110, passes through the focusing lens 27 and then is irradiated onto the object to be irradiated W as shown in Fig. 1A. When the laser beam LB is focused by the focusing lens 27, as shown in Fig. 1B, a spot size (radius) W(Z) at a focusing point of the focused laser beam LB takes the minimum value W₀ at a certain point on an optical axis. The point at which the spot size W(Z) in the focused laser beam LB becomes the minimum value W₀ is referred to as a beam waist BW. A spot size W(Z) of the focused laser beam LB at a position away from the beam waist BW by the Rayleigh length Z_{R} is √2 times the spot size W₀ of the laser beam LB at the beam waist BW.

There are two positions which are away from the beam waist BW by the Rayleigh length Z_{R}, one of the two positions is on a side closer to the focusing lens 27 shown in Fig. 1A than the position of the beam waist BW of the focused laser beam LB, and the other of the two positions is on a side opposite to the focusing lens 27. A focal depth b of the focused laser beam LB shown in Fig. 1B is a distance between a position away from the beam waist BW toward the focusing lens 27 side by the Rayleigh length Z_{R}, and a position away from the beam waist BW toward the side opposite to the focusing lens 27 by the Rayleigh length Z_{R}. The position away from the beam waist BW toward the focusing lens 27 side by the Rayleigh length Z_{R} is referred to as an inner focus position, and the inner focus position is shown as "Pi" in Fig. 1B. Further, the position away from the beam waist BW toward the side opposite to the focusing lens 27 by the Rayleigh length Z_{R} is referred to as an outer focus position, and the outer focus position is shown as "Po" in Fig. 1B. At the inner focus position Pi and the outer focus position Po, a cross-sectional area of the laser beam LB is twice a cross-sectional area of the laser beam LB at the beam waist BW. In FIG. 1B, θ indicates a divergence angle of the laser beam LB focused by the focusing lens 27.

In the laser irradiation method and the laser irradiation apparatus of the present disclosure described below, a range from the beam waist BW of Fig. 1B of the laser beam LB focused by the focusing lens 27 shown in Fig. 1A to positions away from the beam waist BW by the Rayleigh length Z_{R} is set as a use range for soldering of the object to be irradiated W.

Fig. 2A shows a case according to the present invention where the laser oscillator 11 includes a plurality of PCSEL elements 110. The plurality of PCSEL elements 110 can be regularly arranged in a two-dimensional manner. The two-dimensional and regular arrangement is, for example, a square lattice shape in which each PCSEL element 110 is arranged in correspondence with each vertex of the square as shown in Fig. 2A. However, the arrangement is not limited thereto, and other arrangements may be used such as other lattice shapes including a hexagonal lattice shape in which each PCSEL element 110 is arranged in correspondence with each vertex of the hexagon, or concentric circles.

In an example shown in Fig. 2A, the plurality of PCSEL elements 110 are mounted on a common circuit board 111. When the plurality of PCSEL elements 110 are mounted on the common circuit board 111, each PCSEL element 110 can be electrically driven in parallel. By electrically driving each PCSEL element 110 in parallel, each PCSEL element 110 can emit the laser beam LB of the same intensity. However, an input current of each PCSEL element 110 may be individually adjusted in order to adjust the individual difference of each PCSEL element 110. In that case, it is not necessary to mount the PCSEL on the common board 111, but the PCSEL may be mounted on individual boards.

The circuit board 111 may be divided into a plurality of parts as shown by dashed lines in Fig. 2A. When the circuit board 111 is divided into a plurality of parts, the plurality of PCSEL elements 110 mounted on each circuit board 111 are regularly arranged in a two-dimensional manner. When each PCSEL element 110 is mounted on each circuit board 111, an input current of each PCSEL element 110 can be individually set. When an input current of each PCSEL element 110 is individually set, the intensity of a laser beam LB emitted by each PCSEL element 110 can be adjusted according to a position irradiated with each laser beam LB.

The plurality of PCSEL elements 110 of the laser oscillator 11 may be regularly arranged in a one-dimensional manner (an example not covered by the present invention). The number of the PCSEL elements 110 of the laser oscillator 11 may be one instead of being more than one (an example not covered by the present invention). The number and arrangement of the PCSEL elements 110 of the laser oscillator 11 may be determined, for example, according to the layout of parts of an object to be irradiated which is subjected to processing such as soldering by means of irradiation with the laser beam LB.

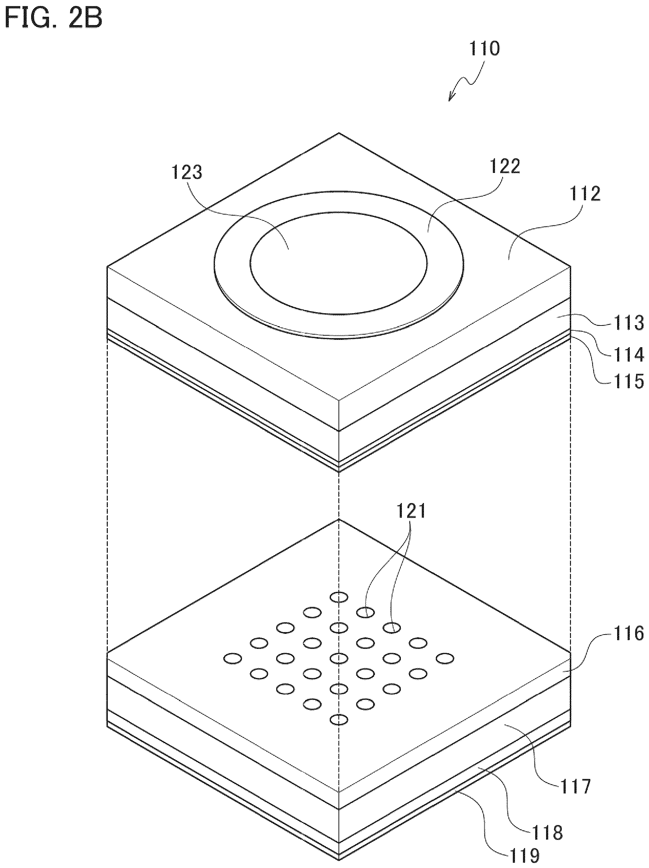

Fig. 2B is a perspective view showing a detailed configuration example of each PCSEL element 110 shown in Fig. 2A. As shown in Fig. 2B, each PCSEL element 110 is configured by laminating a substrate 112, an n-type cladding layer 113, an active layer 114, a carrier block layer 115, a photonic crystal layer 116, a p-type cladding layer 117, a p-type contact layer 118, and a back electrode 119. In Fig. 2B, the carrier block layer 115 and the photonic crystal layer 116 are shown in a separated state so that a configuration of the photonic crystal layer 116 can be easily seen.

A Distributed Bragg Reflector (DBR) layer (not shown) is provided between the p-type cladding layer 117 and the p-type contact layer 118. The distributed bragg reflector layer reflects light directing toward the back electrode 119 in an emission direction. A plurality of holes 121 are formed in the photonic crystal layer 116.

A ring-shaped window electrode 122 is provided on a surface of the substrate 112. A window part 123 by an AntiReflection (AR) coat layer is provided on an inner side of the window electrode 122. The window part 123 serves as an emission surface of a laser beam LB from each PCSEL element 110.

In each PCSEL element 110, light generated in the active layer 114 due to the energization between the back electrode 119 and the window electrode 122 is diffracted in a direction of 90 degrees or 180 degrees in the holes 121 of the photonic crystal layer 116 which exhibits a binding effect on the light. A standing wave along a crystal direction is generated inside the photonic crystal layer 116 due to the interference of the diffracted light.

The diffraction of the light in the holes 121 occurs not only in a direction in a plane of the photonic crystal layer 116 but also in a direction orthogonal to this plane.

Among light extracted from the photonic crystal layer 116, light traveling toward the substrate 112 passes through the window part 123 on the inner side of the window electrode 122 and is radiated to the outside of each PCSEL element 110. Among the light extracted from the photonic crystal layer 116, light traveling toward the back electrode 119 is reflected by the distributed bragg reflector layer. The light reflected by the distributed bragg reflector layer passes through the window part 123 together with the light traveling toward the substrate 112, and is radiated to the outside of each PCSEL element 110. The light radiated through the window part 123 of each PCSEL element 110 becomes coherent light.

Each PCSEL element 110 emits coherent light radiated through the window part 123 as the laser beam LB. The laser beam LB emitted by each PCSEL element 110 is substantially collimated light in a watt class. The laser beam LB emitted by each PCSEL element 110 has a Gaussian waveform intensity distribution in a beam radial direction.

The laser oscillator 11 shown in Fig. 1A outputs the laser beam LB emitted by each energized PCSEL element 110. When the plurality of energized PCSEL elements 110 emit laser beams LB, the laser beams LB output by the laser oscillator 11 become multi-beams.

The laser processing unit 15 has a processing table 21, an X-axis carriage 22, a Y-axis carriage 23, and a processing head 24 fixed to the Y-axis carriage 23. A printed substrate W to be processed with the laser beam LB is mounted on the processing table 21.

The X-axis carriage 22 is formed into a gate shape and is movable in an X-axis direction on the processing table 21 by spanning the printed substrate W. The Y-axis carriage 23 is movable in a Y-axis direction perpendicular to the X-axis direction on the X-axis carriage 22. The X-axis carriage 22 and Y-axis carriage 23 can move the entire processing head 24 including a nozzle 26 relatively to the printed substrate W on the processing table 21 along a surface of the printed substrate W in the X-axis direction, the Y-axis direction, or any combination direction of the X-axis and the Y-axis.

Instead of moving the processing head 24 along the surface of the printed substrate W in the X-axis direction and Y-axis direction, a position of the processing head 24 may be fixed and the printed substrate W or the processing table 21 on which the printed substrate W is mounted may move in the X-axis direction and the Y-axis direction.

The processing head 24 as a laser head has a bend mirror 25 for reflecting the laser beam LB propagated in the protection unit 30, and the nozzle 26 for emitting the laser beam LB reflected by the bend mirror 25 to the printed substrate W on the processing table 21. The processing head 24 further has the focusing lens 27 for focusing the laser beam LB reflected by the bend mirror 25 and emitting the laser beam from the nozzle 26. The focusing lens 27 is movable in the processing head 24 in a Z-axis direction perpendicular to the X-axis and Y-axis.

Instead of moving the focusing lens 27 in the processing head 24 in the Z-axis direction, a position of the focusing lens 27 may be fixed in the processing head 24, and the printed substrate W or the processing table 21 on which the printed substrate W is mounted may move in the Z-axis direction.

The X-axis carriage 22, Y-axis carriage 23, and processing head 24 function as moving mechanisms for moving the printed substrate W, which is an object to be irradiated, relative to the processing head 24 in the X-axis direction, Y-axis direction, and Z-axis direction. That is, it is sufficient if the laser irradiation apparatus 100 has a moving mechanism for moving the processing head 24 relative to the surface of the printed substrate W.

The protection unit 30 has a mirror housing 32 connected to the laser oscillator 11 with a bellows optical path cover 31 therebetween, and a mirror housing 35 connected to the mirror housing 32 with a bellows optical path cover 34 therebetween. The mirror housing 32 houses an X-axis bend mirror 33 and the mirror housing 35 houses a Y-axis bend mirror 36.

The optical path cover 31 protects, from external elements, the laser beam LB emitted by each PCSEL element 110 of the laser oscillator 11 and directed to the X-axis bend mirror 33. The optical path cover 34 protects, from external elements, the laser beam LB reflected by the X-axis bend mirror 33 and directed to the Y-axis bend mirror 36. The laser beam LB reflected by the Y-axis bend mirror 36 is reflected by the bend mirror 25 of the processing head 24 and emitted from the nozzle 26 of the processing head 24 toward the processing table 21.

In the protection unit 30, the laser beam LB is transmitted from the laser oscillator 11 to the focusing lens 27 of the processing head 24 by means of spatial propagation except for reflection by the X-axis bend mirror 33, Y-axis bend mirror 36, and bend mirror 25. The spatial propagation is performed by means of wireless transmission without spectroscopy, focusing, and transmission using an optical transmission path. The protection unit 30 may directly connect the laser oscillator 11 and the processing head 24 with bellows optical path cover. In this case, the mirror housings 32 and 35, the X-axis bend mirror 33, and the Y-axis bend mirror 36 can be omitted.

According to the above configuration, the laser irradiation apparatus 100 transmits the laser beam LB emitted from the laser oscillator 11 to the processing head 24 by means of the protection unit 30, irradiates the printed substrate W with the laser beam having a high energy density to perform soldering to the printed substrate W.

A laser light source for processing such as soldering has changed from a gas laser of CO2 to a solid laser such as YAG (a crystal of a garnet structure by a compound oxide of yttrium and aluminum) and a slab laser, and then to a fiber laser. A direct diode laser (DDL) using a diode laser, which is a pump light source for a fiber laser, is available in the market as the laser light source for processing.

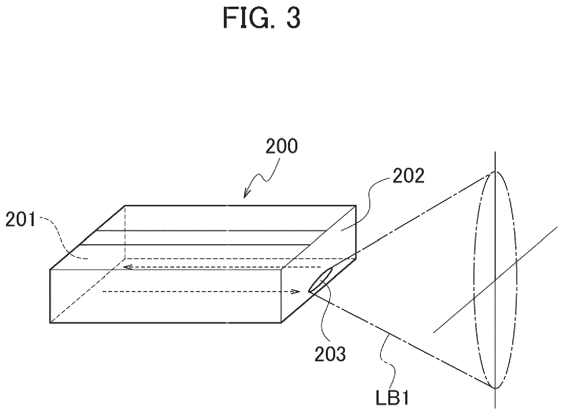

An example of the DDL is a Fabry-Perot diode laser. Fig. 3 is a diagram showing a principle of laser beam emission by the Fabry-Perot diode laser used as the laser light source for processing.

In a Fabry-Perot (hereinafter abbreviated as "FP") diode laser 200 shown in Fig. 3, an optical resonator is configured in which left and right end surfaces 201 and 202 in the diagram serve as mirrors, and light reciprocates between both of the mirrors. A light-emitting part 203 for emitting a laser beam LB1, located at the right end surface 202 has an elongated line shape, and has a dimension of, for example, about 100 µm horizontally and less than 1 µm vertically. A divergence angle of the laser beam LB1 emitted from the light-emitting part 203 is, for example, a full angle of 10 degrees horizontally and a full angle of 60 degrees vertically. Therefore, the quality of the laser beam LB1 emitted from the FP diode laser 200 differs greatly in the vertical direction and the horizontal direction.

Therefore, when the FP diode laser 200 is used as the laser light source for processing, a complicated optical system is required to form a shape of an emitted beam. Further, when the FP diode laser 200 is used as the laser light source for processing, it is necessary to focus the laser beam LB1 so that the energy density distribution is uniform.

Each issue of the beam shape and the energy density distribution is solved by inputting the laser beam LB1 emitted from the light-emitting part 203 of the FP diode laser 200 into an optical fiber and configuring a fiber coupled laser diode (hereinafter abbreviated as "FCLD"). In the FCLD, while the laser beam LB1 is transmitted in the optical fiber, the laser beam LB1 can be shaped to have a circular-beam cross section, and the energy density distribution of the laser beam LB can be made uniform.

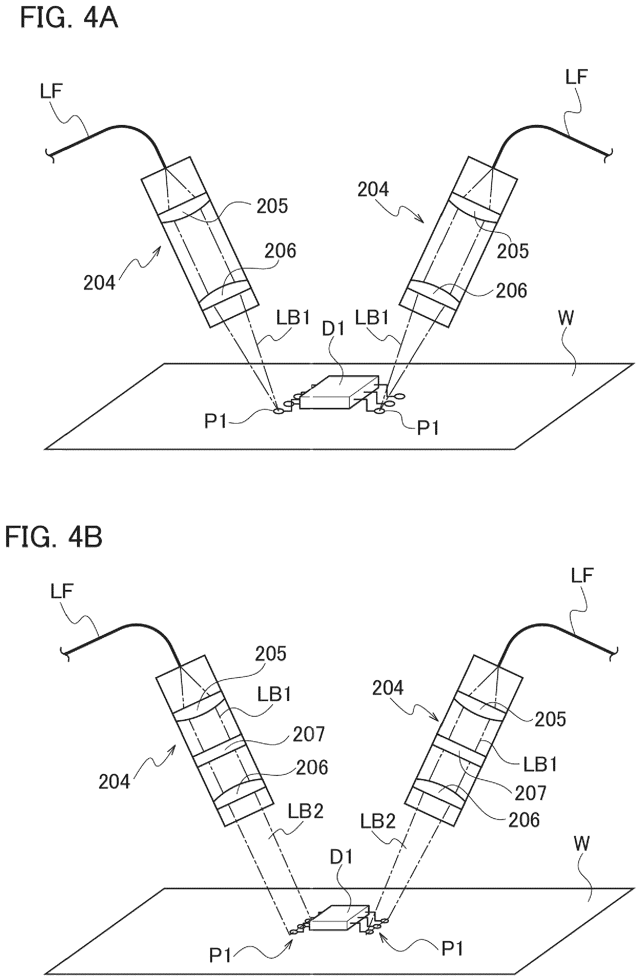

Fig. 4A is a diagram showing an example of a soldering operation performed on a printed substrate by a general laser soldering apparatus using the FCLD as a laser light source. Fig. 4B is a diagram showing an example of an operation when soldering is performed on a printed substrate by the laser soldering apparatus of Fig. 4A using a line-shaped laser beam.

A laser beam emitted from an end surface of the optical fiber of the FCLD becomes divergent light in which a diameter of a beam cross section gradually increases. In a laser soldering apparatus using the FCLD emitting divergent light as a laser light source, as shown in Fig. 4A, laser beams LB1 as divergent light emitted from end surfaces of optical fibers LF of the FCLDs are collimated by collimating lenses 205 of the processing heads 204. The collimated laser beams LB1 are focused by the focusing lenses 206 and are irradiated onto solders (not shown) arranged at soldering points P1 of terminals of an electrical component D1 on the printed substrate W.

When the electrical component D1 having terminals on both sides is soldered, if the terminals on both sides are not soldered to the soldering points P1 simultaneously, the electrical component D1 is fixed in a cantilevered manner due to terminals on only one side being soldered before terminals on the other side, and therefore the electrical component D1 may be inclined relative to the printed substrate W. When the electrical component D1 is inclined, terminals on the other side are separated from the printed substrate W, and it becomes difficult to solder the terminals to the soldering points P1. In order to avoid the inclination of the electrical component D1 due to soldering, as shown in Fig. 4A, it is effective to solder the terminals on both sides of the electrical component D1 simultaneously using the laser beams LB1 from the plurality of processing heads 204.

When a plurality of terminals are present on each side of the electrical component D1, as shown in Fig. 4B, a beam shaping element 207 is arranged between a collimating lens 205 and a focusing lens 206 of each processing head 204, and a laser beam LB2 is shaped into a line shape by the beam shaping element 207. The shaped line laser beam LB2 spans a plurality of soldering points P1 corresponding to a plurality of terminals on each side of the electrical component D1, and is irradiated onto solders (not shown) of the soldering points PL.

Incidentally, in the high-power FP diode laser 200 used for a processing application, many longitudinal modes are oscillated, and the wavelength width of oscillation spectrums reaches 2 to 4 nm at half maximum. In addition, in the high-power FP diode laser 200, the temperature dependence of the wavelength is large, and a wavelength shift of 0.25 to 0.3 nm/°C is observed due to a temperature change of a cooling part or a change in a heat radiation amount due to a difference in the output.

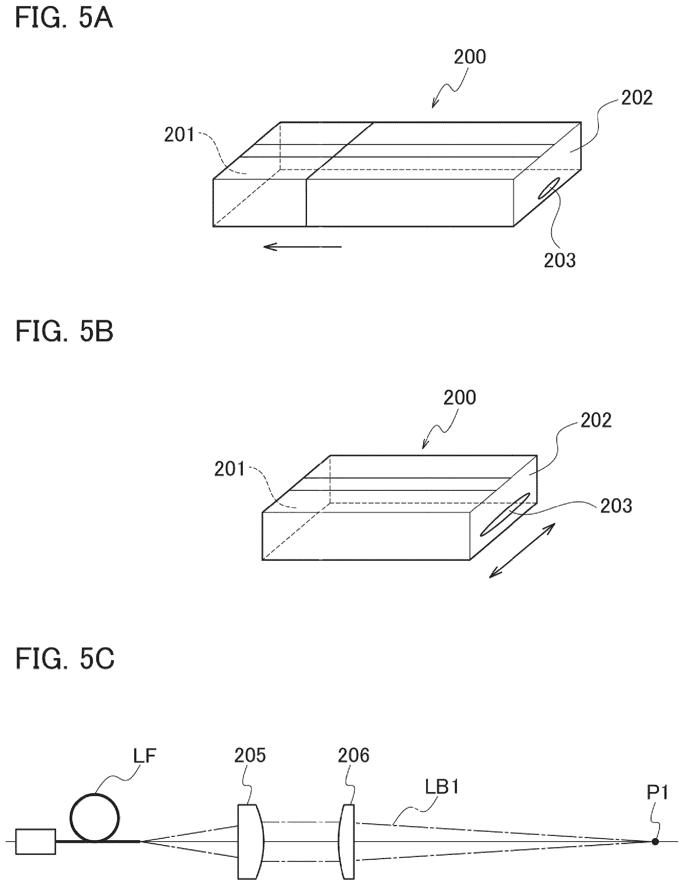

Fig. 5A is a diagram showing a case where outputs of the laser beams LB1 and LB2 are increased by increasing the length of the optical resonator in the FP diode laser 200. Fig. 5B is a diagram showing a case where outputs of the laser beams LB1 and LB2 are increased by increasing the width of the light-emitting part 203 in the FP diode laser 200.

In the FP diode laser 200, outputs of the laser beams LB1 and LB2 can be increased by increasing the length of the optical resonator as shown in Fig. 5A or by increasing the width of the light-emitting part 203 as shown in Fig. 5B.

However, when the length of the optical resonator is increased, since the width of the light-emitting part 203 does not change, the brightness of a laser beam emitted from the light-emitting part 203 increases, the light-emitting part 203 causes Catastrophic optical damage (COD), and therefore there are limitations on the increase in outputs. Further, when the width of the light-emitting part 203 is increased, the quality of a laser beam in a horizontal direction, which is lower than that in a vertical direction, further deteriorates, and it becomes difficult to focus a laser beam and input a laser beam to a fiber.

Fig. 5C is a diagram showing an example of a focusing optical path of the laser beam LB1 emitted by the FCLD in the laser soldering apparatus of Fig. 4A. The laser beam LB1 emitted by the FP diode laser 200 is collimated by the collimating lens 205, then focused by the focusing lens 206, and irradiated onto the soldering points P1.

Since the focal length of the collimating lens 205 is limited by a lens diameter, it is not possible to increase the focal length. When the priority is to reduce a beam diameter of the laser beam LB1 at the soldering point P1 so that a necessary energy density can be obtained at the soldering point P1, it is necessary to reduce the focal length of the focusing lens 206.

When the focal length of the focusing lens 206 is reduced, the Rayleigh length of the focused laser beam LB1 is reduced. If the Rayleigh length of the laser beam LB1 is short, when a position of the soldering point P1 deviates in the Z-axis direction due to warping of the printed substrate W, the position of the soldering point P1 is likely to be outside a range of the Rayleigh length of the laser beam LB1, for example.

Incidentally, as is well known, the Rayleigh length of the laser beam LB1 is a distance between the focusing point of the laser beam LB1 and a position where a beam cross-sectional area of the laser beam LB1 is twice a beam cross-sectional area at the focusing point. The focusing lens 206 side from the beam waist position of the laser beam LB1 is referred to as an inner focus side, and an opposite side of the focusing lens 206 is referred to as an outer focus side. The range of the Rayleigh length extends to both the inner focus side and the outer focus side.

The focal depth of the Rayleigh length indicates a range where a focusing diameter of the laser beam LB1 by the focusing lens 206 is equal to or less than V2 times the focusing point, and therefore, in the focal depth of the Rayleigh length, the energy density of the laser beam LB1 is reduced to half of the highest energy density of the focusing point at the maximum. In the range of the Rayleigh length of the laser beam LB1, the focal depth is not necessarily applicable to all laser processing. However, at least when the laser beam LB1 is used for soldering at the soldering point P1, by using the focal depth as the Rayleigh length, the laser beam LB1 having the necessary energy density can be irradiated onto the soldering point P1.

However, as described above, when the position of the soldering point P1 is outside the range of the Rayleigh length of the laser beam LB1, it is not possible to irradiate the soldering point P1 with the laser beam LB1 having the necessary energy density, and soldering may not be performed appropriately.

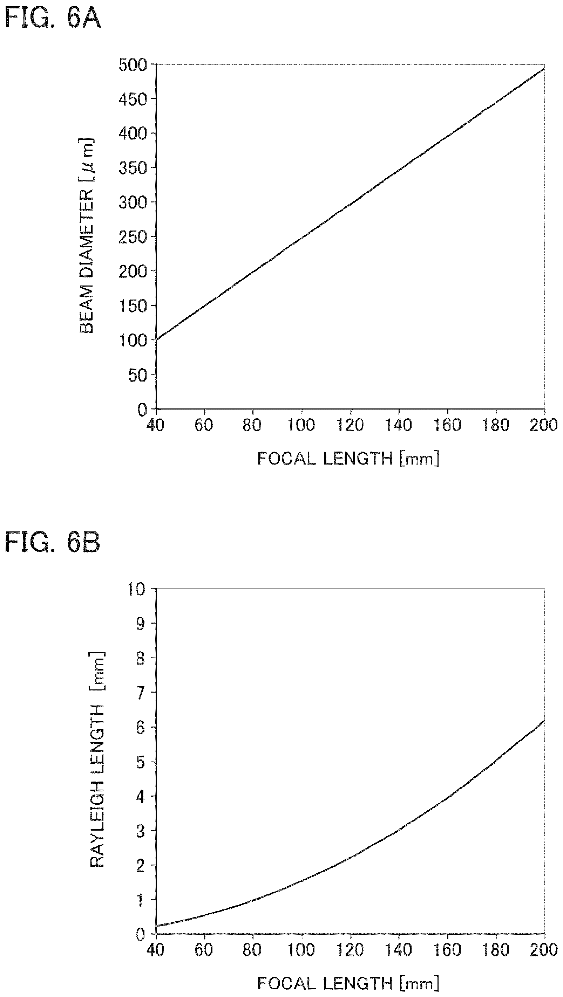

Fig. 6A is a graph showing an example of the relationship between the focal length of the focusing lens 206 and a beam diameter of the focused laser beam LB1 when the laser beam LB1 emitted by the FCLD is collimated and then focused by the focusing lens 206. Fig. 6B is a graph showing an example of the relationship between the focal length of the focusing lens 206 shown in Fig. 6A and the Rayleigh length of the focused laser beam LB1.

Fig. 6A shows the laser beam LB1 emitted by the FCLD when the laser beam LB1 emitted from the FP diode laser 200 is input to the optical fiber, and a wavelength λ of the laser beam LB1 is 948 nm. A core diameter φ of the optical fiber of the FCLD is 100 µm, a numerical aperture NA thereof is 0.2, and a focal length f of the collimating lens 205 for collimating the laser beam LB1 emitted by the FCLD is 40 mm.

Generally, in many cases, a beam diameter of a laser beam used for soldering is about 100 to 400 µm. As can be seen from the relationship shown in Fig. 6A, in order to reduce a beam diameter of the laser beam LB1 to 100 to 400 µm, it is necessary to use a focusing lens 206 having a focal length of 40 to 160 mm. As can be seen from the relationship shown in Fig. 6B, the Rayleigh length of the laser beam LB1 focused by the focusing lens 206 having a focal length of 40 to 160 mm is about 4 mm at the longest.

In the laser soldering apparatus shown in Fig. 4A or 4B, even if each soldering point P1 is deviated by only several millimeters in the Z-axis direction, a position thereof is outside a range of the Rayleigh length of the laser beam LB1 or LB2, and it is not possible to irradiate each soldering point P1 with the laser beam LB1 or LB2 having a necessary energy density.

Meanwhile, when meeting a space requirement in a laser soldering apparatus is a priority, another problem occurs. There are space limitations on a lens diameter of the collimating lens 205 shown in Fig. 5C and a distance from an end surface of the optical fiber LF to the collimating lens 205 in the optical axis direction of the laser beam LB1. Therefore, there are upper limitations on the length of the focal length of the collimating lens 205.

In addition, since it is not possible to use a lens with a long focal length for the collimating lens 205, there is a demand to shorten the focal length of the focusing lens 206 such that the necessary energy density can be obtained at the soldering point P1. However, in order to ensure a necessary distance, there are lower limitations on a distance from a surface of the focusing lens 206 to the soldering point P1 on a focal position of the focusing lens 206 (also referred to as a working distance) in the optical axis direction of the laser beam LB1.

Therefore, when meeting a space requirement in a laser soldering apparatus is a priority, it becomes difficult to sufficiently reduce a beam diameter of the laser beam LB1 at the soldering point P1 such that the necessary energy density can be obtained at the soldering point P1.

In the laser irradiation apparatus 100 of the present embodiment shown in Figs. 1A, 1B, 2A, and 2B, the PCSEL element 110 used in the laser oscillator 11 oscillates in a single mode. The PCSEL element 110 having a radiation region φ 1 mm oscillates substantially with collimated light, for example. The PCSEL element 110 emits collimated light as the laser beam LB, and therefore a collimating lens for collimating the laser beam LB becomes unnecessary. Accordingly, in meeting a space requirement in the laser irradiation apparatus 100, it is not necessary to consider the presence of a collimating lens and a focal length.

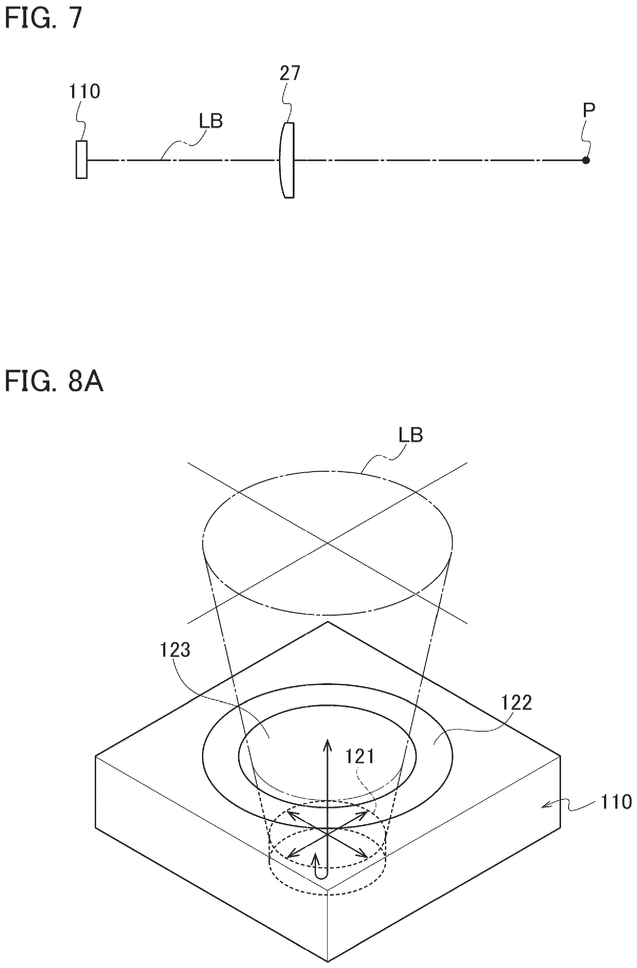

Fig. 7 is a diagram showing an example of a focusing optical path of the laser beam LB emitted by the PCSEL element 110 shown in Fig. 2B in the laser irradiation apparatus 100 shown in Fig. 1A. The laser beam LB emitted by the PCSEL element 110 is focused by the focusing lens 27 and then irradiated onto a soldering point P of the printed substrate W.

Since the PCSEL element 110 oscillates in a single mode, the quality of the laser beam LB emitted by the PCSEL element 110 is higher than the quality of the laser beam LB1 or LB2 of Fig. 4A or 4B emitted by the FCLD. Therefore, even if the focusing lens 27 having a long focal length is used, it is possible to reduce a beam diameter of the laser beam LB to a beam diameter sufficient to obtain the necessary energy density at the soldering point P of the printed substrate W.

Since a lens having a longer focal length than the focusing lens 206 can be used for the focusing lens 27, and a beam diameter of a beam entering the focusing lens 27 is small, it is possible to increase the Rayleigh length Z_{R} of the coherent light of the laser beam LB focused by the focusing lens 27 and expand a range of the Rayleigh length Z_{R}. Since the range of the Rayleigh length Z_{R} of the coherent light is expanded, even if the position of the soldering point P1 is deviated in the Z-axis direction due to warping of the printed substrate W, the position of the soldering point P1 is less likely to be outside the range of the Rayleigh length Z_{R} of the coherent light. Therefore, even if the position of the soldering point P1 is deviated in the Z-axis direction, it is possible to easily irradiate the soldering point P1 with the coherent light of the laser beam LB having the necessary energy density.

The laser beam LB is emitted from the window part 123 on the inner side of the window electrode 122 on an anode side of the PCSEL element 110 shown in Fig. 2B, for example. When a diameter φ of the window part 123 is 1 mm and a focal length f of the focusing lens 27 is 100 mm, a beam diameter φ of the laser beam LB at the focal position of the focusing lens 27 is 200 µm, for example. Since the laser beam LB entering the focusing lens 27 is coherent light with a small beam diameter φ of 1 mm, the long Rayleigh length Z_{R} can be ensured. Since the diameter of the focusing lens 27 can be reduced, a space necessary for the arrangement of the focusing lens 27 can be minimized.

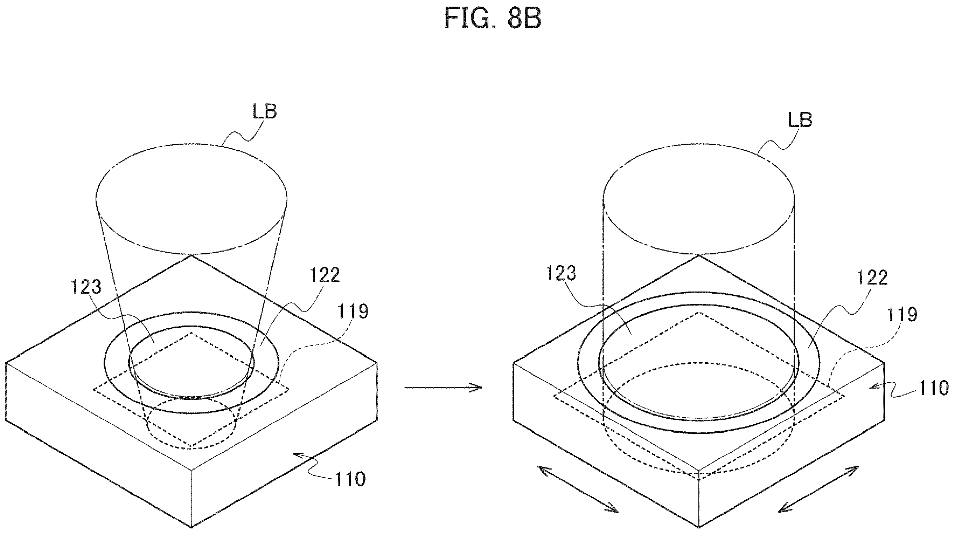

Fig. 8A is a diagram showing that the PCSEL element 110 shown in Fig. 2B confines light in an in-plane direction by means of a photonic crystal and radiates light in a vertical direction. Fig. 8B is a diagram showing an example of increasing a radiation area of a laser beam in the PCSEL element 110 shown in Fig. 2B and achieving higher output.

When a current is supplied to the PCSEL element 110 shown in Fig. 2B, the laser beam LB is emitted from the window part 123 of the PCSEL element 110 as shown in Fig. 8A. The laser beam LB emitted from the window part 123 is radially emitted from a central axis passing through the center of the window electrode 122. Since the PCSEL element 110 can oscillate in a single mode irrelevant to the area of the window part 123 thereof, as shown in Fig. 8B, when the radiation area of the laser beam LB is increased in order to increase the output of the laser beam LB, reversely a beam spread angle of the laser beam LB becomes small.

Since an output of the laser irradiation apparatus 100 is required to have a watt level, the radiation region of the PCSEL element 110 has a large diameter, and in accordance with this, the beam spread angle of the laser beam LB becomes smaller. Therefore, in the PCSEL element 110 of the laser irradiation apparatus 100, the laser beam LB can be focused to have a sufficiently small beam diameter by the focusing lens 27 even if a collimating lens is not used.

The laser beam LB emitted by the PCSEL element 110 has excellent longitudinal mode characteristics, and therefore an oscillation spectrum of the laser beam LB is less than 0.1 nm at half maximum, and the wavelength shift by temperature is also less than 0.1 nm/°C. Therefore, the change in the wavelength of the laser beam LB due to the change in the output of the laser beam LB is small. Further, the PCSEL element 110 oscillating in a single mode can optically control the emitted laser beam LB easily because the laser beam has a circular shape and has the Gaussian waveform intensity distribution. Therefore, the PCSEL element 110 can easily respond to an increase in the output of the laser beam LB.

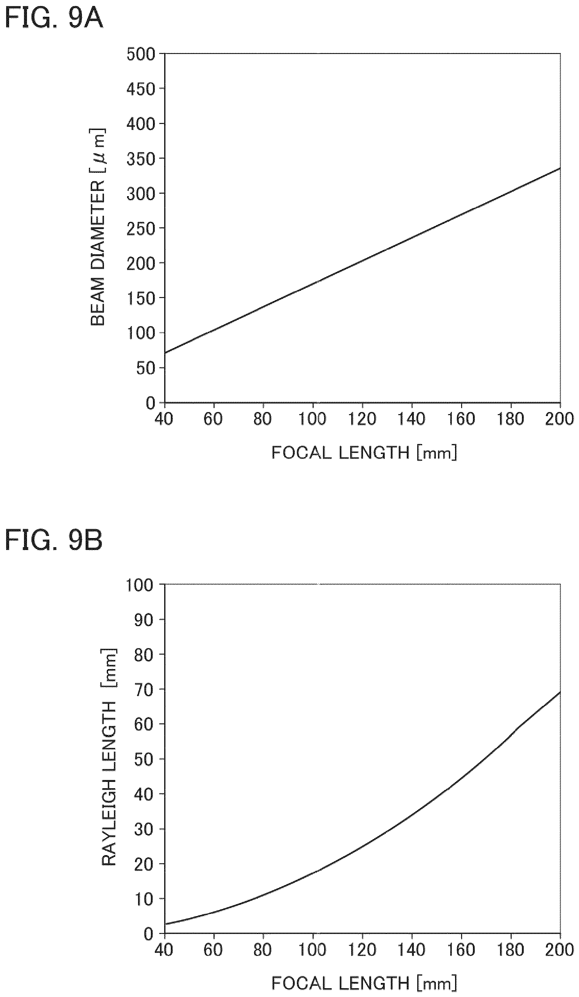

Fig. 9A is a graph showing an example of the relationship between the focal length of the focusing lens 27 for focusing the single mode laser beam LB emitted by the PCSEL element 110 shown in Fig. 2B in the laser irradiation apparatus 100 shown in Fig. 1A, and the beam diameter of the focused laser beam LB. Fig. 9B is a graph showing an example of the relationship between the focal length of the focusing lens 27 shown in Fig. 9A and the Rayleigh length Z_{R} of the focused laser beam LB. Fig. 9A shows the relationship between the focal length of the focusing lens 27 in the PCSEL element 110 and the beam diameter of the focused laser beam LB, and in the PCSEL element 110, the wavelength λ of the laser beam LB is 948 nm, the beam quality M2 is 1.5, and a diameter φ of the window part 123 is 1 mm, for example.

The laser beam LB emitted by the PCSEL element 110 is substantially collimated light with a high quality and a small divergence angle because the laser beam is in a single mode, and therefore the laser beam LB enters the focusing lens 27 with a small beam diameter even if the laser beam is not collimated by the collimating lens. When the focusing lens 27 with a focal length of 60 mm to 110 mm is used, as shown in Fig. 9A, a beam diameter of the laser beam LB at the focal position of the focusing lens 27 can be 100 to 200 µm, for example. Further, the Rayleigh length Z_{R} of the laser beam LB focused by the focusing lens 27 with a focal length of 60 mm to 110 mm is 5 to 20 mm as can be seen from the relationship shown in Fig. 9B.

In the laser irradiation apparatus 100 shown in Fig. 1A, even if the soldering point P is deviated by several millimeters in the Z-axis direction, the laser beam LB can be irradiated onto the soldering point P within the range of the Rayleigh length Z_{R} of the laser beam LB. When a focusing lens 27 having a focal length of 120 mm is used as the focusing lens 27, according to the relationship shown in Fig. 9B, even at a position deviated by 20 mm or more in the Z-axis direction from the focal position of the focusing lens 27, the positon of the soldering point P is less likely to be outside the range of the Rayleigh length Z_{R} of the coherent light of the laser beam LB.

Similar to the Rayleigh length of the laser beam LB1 shown in Fig. 5C, the Rayleigh length Z_{R} of the laser beam LB shown in Fig. 1B indicates a distance between the focusing point of the laser beam LB and a position where a beam cross-sectional area of the laser beam LB is twice a beam cross-sectional area at the focusing point. That is, the range of the Rayleigh length Z_{R} extends to both the inner focus side and the outer focus side.

In the focal depth b of the Rayleigh length Z_{R}, the energy density of the laser beam LB is reduced to half of the highest energy density of the focusing point at the maximum. However, at least to the extent that the laser irradiation method and the laser irradiation apparatus of the present disclosure are applied to soldering of the present embodiment, the laser beam LB having the necessary energy density can be irradiated onto the soldering point P by setting the focal depth to the Rayleigh length Z_{R}.

When the soldering point P is deviated in the Z-axis direction, a position of the printed substrate W irradiated with the laser beam LB may be deviated from the position of the soldering point P in at least one direction of the X-axis direction and the Y-axis direction. In this case, a relative position of the printed substrate W and the processing head 24 is adjusted such that the position of the soldering point P is irradiated with the laser beam LB.

In the laser irradiation apparatus 100 of the present embodiment, it is possible to increase the Rayleigh length Z_{R} of the laser beam LB focused by the focusing lens 27, and in the wide range of the Rayleigh length Z_{R}, the laser beam LB for processing having the necessary energy density can be irradiated onto the printed substrate W.

The PCSEL element 110 for emitting the laser beam LB from the window part 123 thereof may be all PCSEL elements 110 mounted on the circuit board 111, or a part of the PCSEL elements 110. When only a part of the PCSEL elements 110 emits the laser beam LB, unnecessary laser beams LB emitted from other PCSEL elements 110 may be blocked by a shutter. Alternatively, it is possible to stop the supply of a current to PCSEL elements 110 which are not required to emit laser beams LB.

When a laser beam LB is irradiated onto one soldering point P of the printed substrate W, a PCSEL element emitting a laser beam LB may be limited to one PCSEL element 110 corresponding to a position of the soldering point P, for example. Further, when a plurality of soldering points P are simultaneously irradiated with laser beams LB, a plurality of PCSEL elements 110 corresponding to each soldering point P can emit the laser beams LB simultaneously. When the plurality of PCSEL elements 110 emit the laser beams LB, multi-spot beams by the plurality of laser beams LB are irradiated onto each soldering point P of the printed substrate **W.**

When laser beams LB are simultaneously emitted from all PCSEL elements 110, multi-spot beams irradiated onto the printed substrate W form a pattern in which the arrangement of the plurality of PCSEL elements 110 is reduced by focusing performed by the focusing lens 27.

The circuit board 111 for supplying a current to the PCSEL element 110 may be a single circuit board common to all PCSEL elements 110, or may be a plurality of circuit boards individually corresponding to each PCSEL element 110. When the circuit board 111 is the single circuit board, it is advantageous to supply a current of the same magnitude to each PCSEL element 110. When the circuit board 111 is the plurality of circuit boards individually corresponding to each PCSEL element 110, it is advantageous to individually control an output of a laser beam LB by each PCSEL element 110.

Each PCSEL element 110 can emit a laser beam LB of an output according to the area of the back electrode 119. The ring-shaped window part 123 can be sized such that the laser beam LB of the output according to the area of the back electrode 119 is emitted without being blocked, for example. By increasing the area of a back electrode 119 of each PCSEL element 110 and setting the area of the window part 123 according to the area of the back electrode 119, the radiation area of the laser beam LB can be increased and the output of the laser beam LB can be increased.

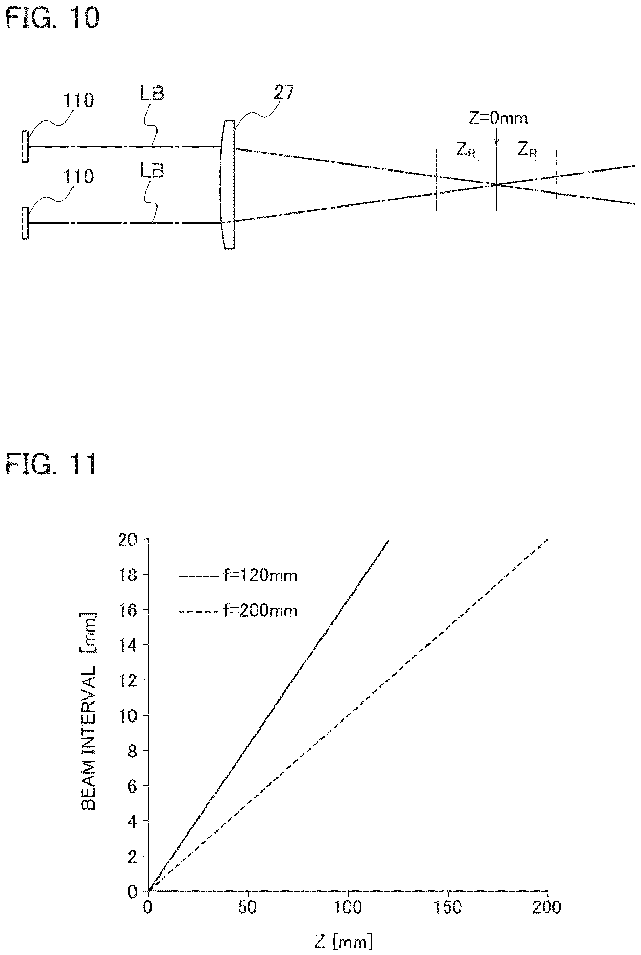

Fig. 10 is a diagram showing examples of optical paths of laser beams LB radiated by two PCSEL elements 110 of Fig. 2B of the laser oscillator 11 shown in Fig. 1A. When the laser beams LB radiated by the two PCSEL elements 110 of Fig. 10 are focused by the focusing lens 27 and then irradiated onto two irradiation positions of the printed substrate W, it is necessary to adjust an interval of the laser beams LB in accordance with an interval of the irradiation positions.

The interval of the laser beams LB varies depending on how much irradiation positions of the printed substrate W irradiated with the laser beams LB are deviated in the Z-axis direction from a focal position (Z = 0 mm) of the focusing lens 27. Further, the interval of the laser beams LB varies depending on the focal length of the focusing lens 27.

Fig. 11 is a graph showing an example of the relationship between a beam interval and the focal length of the focusing lens 27 of the two laser beams LB shown in Fig. 10. When a position where the two laser beams LB intersect is set as Z = 0 mm, Fig. 10 shows a beam interval at a position which is deviated by Z mm from the position in the inner focus side or the outer focus side.

When an interval between the irradiation positions of the printed substrate W is 6 mm and the focal length of the focusing lens 27 is 120 mm, an interval between the two laser beams LB is 6 mm at a position which is deviated by about 40 mm from the position of the focal point (Z = 0 mm), for example. When the focal length of the focusing lens 27 is 200 mm, an interval between the two laser beams LB is 6 mm at a position which is deviated by 60 mm from the position of the focal point (Z = 0 mm).

Therefore, when a focusing lens 27 having a focal length of 120 mm is used, whether the Rayleigh length Z_{R} of a focused laser beam LB is 40 mm or more is confirmed. Further, when a focusing lens 27 having a focal length of 200 mm is used, whether the Rayleigh length Z_{R} of a focused laser beam LB is 60 mm or more is confirmed.

When the Rayleigh length Z_{R} is equal to or longer than the length to be compared, by deviating the positions irradiated with the laser beams LB by a distance according to the focal length of the focusing lens 27 from the focal position of the focusing lens 27, the two laser beams LB can be irradiated onto the printed substrate W at an interval equal to an interval between the irradiation positions. A direction in which the printed substrate W is deviated can be either the inner focus side or the outer focus side. The processing head 24 may be deviated instead of the printed substrate W.

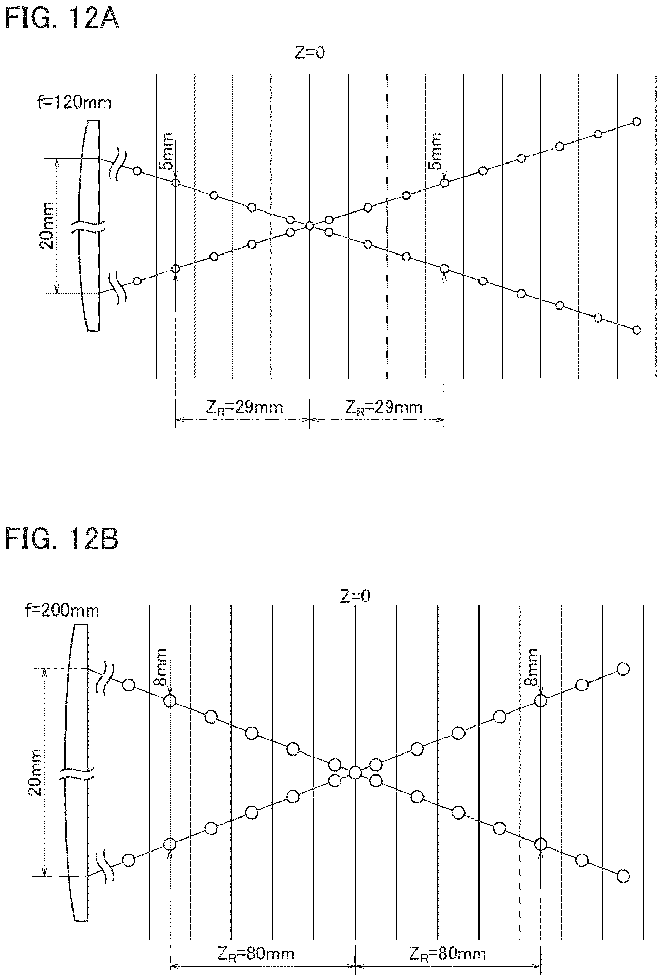

Fig. 12A is a diagram showing a position of each laser beam LB in a range of the Rayleigh length Z_{R} when the two laser beams LB shown in Fig. 10 are focused by one focusing lens 27 having a focal length of 120 mm for each distance from a focal plane of the focusing lens 27. Fig. 12B is a diagram showing a position of each laser beam LB in a range of the Rayleigh length Z_{R} when the two laser beams LB shown in Fig. 10 are focused by one focusing lens 27 having a focal length of 200 mm for each distance from a focal plane of the focusing lens 27.

In both Figs. 12A and 12B, a position of the printed substrate W is deviated from a position of the focal plane of the focusing lens 27 in a range of the Rayleigh length Z_{R} of the laser beam LB, and accordingly soldering can be performed simultaneously at different positions of the printed substrate W by irradiating the positions with the laser beams LB. The position of the printed substrate W deviated from the position of the focal plane of the focusing lens 27 can be either the inner focus side or the outer focus side.

The positions of the printed substrate W irradiated with the laser beams LB that have been focused by the focusing lens 27 shown in Fig. 1A may be limited in a range of the Rayleigh length Z_{R} from the beam waist BW to the inner focus position Pi shown in Fig. 1B. The positions of the printed substrate W irradiated with the laser beams LB that have been focused by the focusing lens 27 may be limited in a range of the Rayleigh length Z_{R} from the beam waist BW to the outer focus position Po shown in Fig. 1B.

At a position where the laser beams LB partially overlap, the printed substrate W can be irradiated with the laser beams LB that are partially overlapped and form a line shape.

In the above embodiment, a case has been described in which an operation to be performed on an object to be irradiated with a laser beams LB is a processing operation such as soldering. However, an operation to be performed on an object to be irradiated with a laser beams LB is not limited to a processing operation. Examples of the operation to be performed on the object to be irradiated with the laser beams LB may include face detection by means of a face authentication system, laser treatment in an ophthalmic practice, and the like.

Further, one PCSEL element 110 may emit laser beams LB simultaneously in a plurality of directions by means of multi-beam radiation.

According to the configuration described above, it is possible to disclose a laser irradiation method comprising:
entering a laser beam emitted from a photonic crystal surface emitting laser element to a focusing lens by spatial propagation; and
irradiating the laser beam focused by the focusing lens onto an object to be irradiated with the laser beam at any irradiation position within a Rayleigh length range regardless of a beam waist position of the laser beam in an optical axis direction of the laser beam.

It is sufficient if the irradiation position of the laser beam is within the Rayleigh length range of the laser beam focused by the focusing lens. Therefore, the irradiation position of the laser beam may be set to an inner focus position on a side closer to the focusing lens than the beam waist position, or an outer focus position on an opposite side of the focusing lens from the beam waist position. Laser beams emitted from a plurality of photonic crystal surface emitting laser elements arranged in a two-dimensional manner is irradiated onto the object to be irradiated at a plurality of irradiation positions. Each of the irradiation positions may be set to a position where two adjacent laser beams partially overlap in a beam radial direction of the laser beams, among the plurality of laser beams emitted from the plurality of photonic crystal surface emitting laser elements arranged in a two-dimensional manner.

The laser beams emitted from the plurality of photonic crystal surface emitting laser elements arranged in a two-dimensional manner and a diameter of the focusing lens may be individually set in correspondence with the irradiation positions of the laser beams emitted from the plurality of photonic crystal surface emitting laser elements.

The plurality of laser beams emitted from the plurality of photonic crystal surface emitting laser elements arranged in a two-dimensional manner is irradiated onto an object to be irradiated with multi-spot beams. The multi-spot beams form a pattern in which the arrangement of the plurality of photonic crystal surface emitting laser elements is reduced by focusing performed by the focusing lens. The plurality of photonic crystal surface emitting laser elements may be individually mounted on circuit boards and arranged in a one-dimensional manner (an example not covered by the present invention) or a two-dimensional manner. The plurality of photonic crystal surface emitting laser elements may be mounted on a single circuit board. Inputs to the plurality of photonic crystal surface emitting laser elements may be individually controlled.

The disclosure of the present application relates to the subject matter of Japanese Patent Application No. 2022-006521, filed on January 19, 2022

## Claims

1. A laser irradiation method comprising:
entering a plurality of laser beams (LB) emitted from a plurality of photonic crystal surface emitting laser elements (110) arranged in a two-dimensional manner to a focusing lens (27) by spatial propagation; and
irradiating the plurality of laser beams (LB) focused by the focusing lens (27) onto an object to be irradiated (W) at a plurality of irradiation positions within a Rayleigh length (Z_{R}) range in an optical axis direction of the plurality of laser beams (LB),
the laser irradiation method being **characterized in that**
the plurality of laser beams (LB) are irradiated onto the object to be irradiated (W) at an interval equal to an interval between a plurality of irradiated points (P) on the object to be irradiated (W) by deviating the plurality of irradiation positions by a distance according to a focal length of the focusing lens (27) from a focal position of the focusing lens (27).

2. The laser irradiation method according to claim 1, wherein
the irradiation position is set to an inner focus position (Pi) on a side closer to the focusing lens (27) than a beam waist (BW) position of the laser beam (LB) focused by the focusing lens (27) or an outer focus position (Po) on an opposite side of the focusing lens (27) from the beam waist (BW) position.

3. The laser irradiation method according to claim 1 or 2, wherein
the laser beams (LB) emitted from the plurality of photonic crystal surface emitting laser elements (110) arranged in a two-dimensional manner are individually set in correspondence with the irradiation positions of the laser beams (LB) emitted from the plurality of photonic crystal surface emitting laser elements (110).

4. The laser irradiation method according to claim 3, wherein
the plurality of laser beams (LB) emitted from the plurality of photonic crystal surface emitting laser elements (110) arranged in a two-dimensional manner are irradiated onto the object to be irradiated (W) with a multi-spot beam, the multi-spot beam forming a pattern in which an arrangement of the plurality of photonic crystal surface emitting laser elements (110) is reduced by focusing performed by the focusing lens (27).

5. The laser irradiation method according to claim 4, wherein
the plurality of photonic crystal surface emitting laser elements (110) are individually mounted on circuit boards and arranged in the two-dimensional manner.

6. The laser irradiation method according to claim 3 or 4, wherein
the plurality of photonic crystal surface emitting laser elements (110) are mounted on a single circuit board.

7. The laser irradiation method according to any one of claims 1 to 5, wherein
inputs to the plurality of photonic crystal surface emitting laser elements (110) are individually controlled.

8. A laser irradiation apparatus (100) comprising:
a plurality of photonic crystal surface emitting laser elements (110) configured to emit a plurality of laser beams (LB);
a laser head (24) configured to focus the plurality of laser beams (LB) emitted from the plurality of photonic crystal surface emitting laser elements (110) arranged in a two-dimensional manner by a focusing lens (27) thereof in an optical transmission path by spatial propagation of the plurality of laser beams (LB);
the laser irradiation apparatus being **characterized by**
a moving mechanism (22, 23 and 24) configured to irradiate the plurality of laser beams (LB) focused by the focusing lens (27) onto an object to be irradiated (W) at a plurality of irradiation positions within a Rayleigh length (Z_{R}) range in an optical axis direction by a movement of the focusing lens (27) relative to the object to be irradiated (W) along the optical axis direction of the plurality of laser beams (LB),
wherein the laser head (24) is configured to be moved so that the plurality of irradiation positions are deviated by a distance according to a focal length of the focusing lens (27) from a focal position of the focusing lens (27), and so that the plurality of laser beams (LB) are irradiated onto the object to be irradiated (W) at an interval equal to an interval between a plurality of irradiated points (P) on the object to be irradiated (W).

## Patentansprüche

1. Laserbestrahlungsverfahren, das umfasst:
Einleiten einer Vielzahl von Laserstrahlen (LB), die von einer Vielzahl zweidimensional angeordneter oberflächenemittierender Photonenkristall-Laserelemente (110) emittiert werden, in eine Fokussierlinse (27) mittels räumlicher Ausbreitung; sowie
Richten der Vielzahl durch die Fokussierlinse (27) fokussierter Laserstrahlen (LB) auf ein zu bestrahlendes Objekt (W) an einer Vielzahl von Bestrahlungspositionen innerhalb eines Bereiches einer Rayleigh-Länge (Z_{R}) in Richtung einer optischen Achse der Vielzahl von Laserstrahlen (LB)
wobei das Laserbestrahlungsverfahren **dadurch gekennzeichnet ist, dass:**
die Vielzahl von Laserstrahlen (LB) auf das zu bestrahlende Objekt (W) in einem Intervall gerichtet werden, das einem Intervall zwischen einer Vielzahl bestrahlter Punkte (P) an dem zu bestrahlenden Objekt (W) gleich ist, durch Verschieben der Vielzahl von Bestrahlungspositionen gegenüber einer Fokusposition der Fokussierlinse (27) um eine Distanz, die einer Brennweite der Fokussierlinse (27) entspricht.

2. Laserbestrahlungsverfahren nach Anspruch 1, wobei
die Bestrahlungsposition auf eine innere Fokuslage (Pi) an einer Seite, die näher an der Fokussierlinse (27) liegt als eine Strahltaillen-Position (BW) des durch die Fokussierlinse (27) fokussierten Laserstrahls (LB) oder eine äußere Fokuslage (Po) an einer der Strahltaillen-Position (BW) gegenüberliegenden Seite der Fokussierlinse (27) festgelegt wird.

3. Laserbestrahlungsverfahren nach Anspruch 1 oder 2, wobei
die von der Vielzahl zweidimensional angeordneter oberflächenemittierender Photonenkristall-Laserelemente (110) emittierten Laserstrahlen (LB) individuell entsprechend den Bestrahlungspositionen von der Vielzahl oberflächenemittierender Photonenkristall-Laserelemente (110) emittierter Laserstrahlen (LB) festgelegt werden.

4. Laserbestrahlungsverfahren nach Anspruch 3, wobei
die Vielzahl von der Vielzahl zweidimensional angeordneter oberflächenemittierender Photonenkristall-Laserelemente (110) emittierter Laserstrahlen (LB) mit einem Multi-Spot-Strahl auf das zu bestrahlende Objekt (W) gerichtet werden, wobei der Multi-Spot-Strahl ein Muster bildet, in dem eine Anordnung der Vielzahl oberflächenemittierender Photonenkristall-Laserelemente (110) durch Fokussierung reduziert wird, die durch die Fokussierlinse (27) durchgeführt wird.

5. Laserbestrahlungsverfahren nach Anspruch 4, wobei
die Vielzahl oberflächenemittierender Photonenkristall-Laserelemente (110) einzeln auf Leiterplatten montiert und zweidimensional angeordnet sind.

6. Laserbestrahlungsverfahren nach Anspruch 3 oder 4, wobei
die Vielzahl oberflächenemittierender Photonenkristall-Laserelemente (110) auf einer einzelnen Leiterplatte montiert sind.

7. Laserbestrahlungsverfahren nach einem der Ansprüche 1 bis 5, wobei
Eingänge in die Vielzahl oberflächenemittierender Photonenkristall-Laserelemente (110) individuell gesteuert werden.

8. Laserbestrahlungsvorrichtung (100), die umfasst:
eine Vielzahl oberflächenemittierender Photonenkristall-Laserelemente (110), die so konfiguriert sind, dass sie eine Vielzahl von Laserstrahlen (LB) emittieren;
einen Laserkopf (24), der so konfiguriert ist, dass er die Vielzahl von Laserstrahlen (LB), die von einer Vielzahl zweidimensional angeordneter oberflächenemittierender Photonenkristall-Laserelemente (110) emittiert werden, mittels einer Fokussierlinse (27) desselben durch räumliche Ausbreitung der Vielzahl von Laserstrahlen (LB) auf einem optischen Übertragungsweg fokussiert;
wobei die Laserbestrahlungsvorrichtung **gekennzeichnet ist durch:**
einen Bewegungsmechanismus (22, 23 und 24), der so konfiguriert ist, dass er die **durch** die Fokussierlinse (27) fokussierte Vielzahl von Laserstrahlen (LB) an einer Vielzahl von Bestrahlungspositionen innerhalb eines Bereiches einer Rayleigh-Länge (Z_{R}) in Richtung einer optischen Achse **durch** eine Bewegung der Fokussierlinse (27) relativ zu einem zu bestrahlenden Objekt (W) in der Richtung der optischen Achse der Vielzahl von Laserstrahlen (LB) auf das zu bestrahlende Objekt (W) richtet,
wobei der Laserkopf (24) so konfiguriert ist, dass er so bewegt wird, dass die Vielzahl von Bestrahlungspositionen gegenüber einer Fokusposition der Fokussierlinse (27) um eine Distanz verschoben werden, die einer Brennweite der Fokussierlinse (27) entspricht, und so, dass die Vielzahl von Laserstrahlen (LB) auf das zu bestrahlende Objekt (W) in einem Intervall gerichtet werden, das einem Intervall zwischen einer Vielzahl bestrahlter Punkte (P) an dem zu bestrahlenden Objekt (W) gleich ist.

## Revendications

1. Procédé d'irradiation laser comprenant :
l'introduction d'une pluralité de faisceaux laser (LB), émis par une pluralité d'éléments laser à émission de surface à cristaux photoniques (110) disposés d'une manière bidimensionnelle, dans une lentille de focalisation (27) par propagation spatiale ; et
l'irradiation de la pluralité de faisceaux laser (LB) focalisés par la lentille de focalisation (27) sur un objet à irradier (W) à une pluralité de positions d'irradiation dans une plage de longueur de Rayleigh (Z_{R}) dans une direction d'axe optique de la pluralité de faisceaux laser (LB),
le procédé d'irradiation laser étant **caractérisé en ce que**
la pluralité des faisceaux laser (LB) est irradiée sur l'objet à irradier (W) à un intervalle égal à un intervalle entre une pluralité de points irradiés (P) sur l'objet à irradier (W) en déviant la pluralité de positions d'irradiation d'une distance conforme à une longueur focale de la lentille de focalisation (27) par rapport à la position focale de la lentille de focalisation (27).

2. Procédé d'irradiation laser selon la revendication 1, dans lequel
la position d'irradiation est établie à une position de focalisation intérieure (Pi) sur un côté plus proche de la lentille de focalisation (27) qu'une position de col de faisceau (BW) du faisceau laser (LB) focalisé par la lentille de focalisation (27) ou à une position de focalisation extérieure (Po) sur un côté opposé de la lentille de focalisation (27) par rapport à la position de col de faisceau (BW).

3. Procédé d'irradiation laser selon la revendication 1 ou 2, dans lequel
les faisceaux laser (LB) émis par la pluralité d'éléments laser à émission de surface à cristaux photoniques (110) disposés d'une manière bidimensionnelle sont établis individuellement en correspondance avec les positions d'irradiation des faisceaux laser (LB) émis par la pluralité d'éléments lasers à émission de surface à cristaux photoniques (110).

4. Procédé d'irradiation laser selon la revendication 3, dans lequel
la pluralité de faisceaux laser (LB) émis par la pluralité d'éléments laser à émission de surface à cristaux photoniques (110) disposés d'une manière bidimensionnelle sont irradiés sur l'objet à irradier (W) avec un faisceau multipoint, le faisceau multipoint formant un motif dans lequel une disposition de la pluralité d'éléments laser à émission de surface à cristaux photoniques (110) est réduite par la focalisation effectuée par la lentille de focalisation (27).

5. Procédé d'irradiation laser selon la revendication 4, dans lequel
la pluralité d'éléments laser à émission de surface à cristaux photoniques (110) sont montés individuellement sur des cartes de circuit imprimé et disposés de la manière bidimensionnelle.

6. Procédé d'irradiation laser selon la revendication 3 ou 4, dans lequel
la pluralité d'éléments laser à émission de surface à cristaux photoniques (110) sont montés sur une carte de circuit imprimé unique.

7. Procédé d'irradiation laser selon l'une quelconque des revendications 1 à 5, dans lequel
les entrées dans la pluralité d'éléments laser à émission de surface à cristaux photoniques (110) sont commandées individuellement.

8. Appareil d'irradiation laser (100) comprenant :
une pluralité d'éléments laser à émission de surface à cristaux photoniques (110) configurés pour émettre une pluralité de faisceaux laser (LB) ;
une tête laser (24) configurée pour focaliser la pluralité de faisceaux laser (LB) émis par la pluralité d'éléments laser à émission de surface à cristaux photoniques (110) disposés d'une manière bidimensionnelle par une lentille de focalisation (27) de celle-ci dans un chemin de transmission optique par propagation spatiale de la pluralité de faisceaux laser (LB) ;
l'appareil d'irradiation laser étant **caractérisé par**
un mécanisme mobile (22, 23 et 24) configuré pour irradier la pluralité de faisceaux laser (LB) focalisés par la lentille de focalisation (27) sur un objet à irradier (W) à une pluralité de positions d'irradiation dans une plage de longueur de Rayleigh (Z_{R}) dans une direction d'axe optique par un déplacement de la lentille de focalisation (27) par rapport à l'objet à irradier (W) le long de la direction d'axe optique de la pluralité de faisceaux laser (LB),
dans lequel la tête laser (24) est configurée pour être déplacée de sorte que la pluralité des positions d'irradiation sont déviées d'une distance conforme à une longueur focale de la lentille de focalisation (27) par rapport à une position focale de la lentille de focalisation (27), et de sorte que la pluralité de faisceaux laser (LB) sont irradiés sur l'objet à irradier (W) à un intervalle égal à un intervalle entre une pluralité de points irradiés (P) sur l'objet à irradier (W).
